# EUROPÄISCHE PATENTSCHRIFT

(11) **EP 2 008 840 B1**
(45) Veröffentlichungstag und Bekanntmachung des Hinweises auf die Patenterteilung: **24.11.2010**
(21) Anmeldenummer: 08011559.5
(22) Anmeldetag: 26.06.2008
(51) Int. Cl.: B60H 1/00

(54) **Vorrichtung zur Kühlung von Elektronikbautteilen**
Device for cooling electronic components
Dispositif de refroidissement de composants électroniques

(30) Priorität: 26.06.2007 DE 102007029635
(43) Veröffentlichungstag der Anmeldung: 31.12.2008
(73) Patentinhaber: Behr GmbH & Co. KG, 70469 Stuttgart (DE)
(72) Erfinder: Fieger, Martin, 71636 Ludwigsburg (DE); Derleth, Martin, 97453 Schonungen (DE)

(56) Entgegenhaltungen:
- DE-A1-102005 013 567
- DE-A1-102005 050 683
- DE-B3- 10 359 064

## Beschreibung

Die Erfindung betrifft eine Vorrichtung zur Kühlung von mindestens einem Elektronikbauteil gemäß dem Oberbegriff des Anspruchs 1.

Um Elektronikbauteile bei Bedarf aktiv zu kühlen, ist es beispielsweise bei Computern bekannt, Lüfter vorzusehen, welche Luft aus der Umgebung ansaugen und dadurch einen Luftstrom vorbei an den Elektronikbauteilen erzeugen, mittels dessen die in den Elektronikbauteilen erzeugte Wärme abgeführt werden kann.

Aus EP 0 897 348 B1 ist eine Vorrichtung zur Halterung und Kühlung von elektronischen Einrichtungen in einem Fahrzeug bekannt. Hierbei ist für die Kühlung der elektronischen Einrichtungen ein Luftkanal, über welchen von einem Gebläse kommende Luft zum Verdampfer geführt wird, mit einem klappengeregelten Bypass ausgebildet. An einer Wand des Bypasses sind die elektronischen Vorrichtungen angebracht, die bei Bedarf mittels durch den Bypass leitbarer Luft gekühlt werden.

Die DE 103 59 064 B3 und die DE 10 2005 013 567 A1 offenbaren Vorrichtungen nach dem Oberbegriff des Anspruchs 1.

Derartige Vorrichtungen zur Kühlung von Elektronikbauteilen, insbesondere in Zusammenhang mit Elektronikbauteilen, die in der Mittelkonsole eines Fahrzeugs eingebaut sind, lassen noch Wünsche offen.

Es ist Aufgabe der Erfindung, eine verbesserte Vorrichtung zur Kühlung von mindestens einem Elektronikbauteil zur Verfügung zu stellen.

Diese Aufgabe wird gelöst durch eine Vorrichtung zur Kühlung von mindestens einem Elektronikbauteil mit den Merkmalen des Anspruchs 1. Vorteilhafte Ausgestaltungen sind Gegenstand der Unteransprüche.

Hierbei ist eine Vorrichtung zur Kühlung von mindestens einem Elektronikbauteil, das in einem Elektronikgehäuse angeordnet ist, wobei Teil der Vorrichtung die Kraftfahrzeug-Klimaanlage ist, mit ihrem Luftführungsgehäuse, in welchem ein Verdampfer und ein Heizer angeordnet sind, von dem mindestens ein Luftkanal abzweigt, über welche temperierte Luft einem innenraum zuführbar ist. Hierbei ist mindestens ein Kaltluftkanal vorgesehen, der hinter dem Verdampfer und vor dem Heizer abzweigt, welcher zum Elektronikgehäuse führt und kalte Luft zum Elektronikbauteil führt, so dass dieses ohne wesentlichen, zusätzlichen Aufwand gekühlt werden kann. Im Unterschied zu üblichen Ausgestaltungen ist kein zusätzliches Gebläse erforderlich. Zudem wird gekühlte Luft zum Elektronikbauteil geführt, so dass der Kühlungseffekt - verglichen mit Luft aus der Umgebung - in den meisten Betriebsbedingungen des Fahrzeugs größer ist.

Der Kaltluftkanal ist in eine Trennwand integriert, die im Luftführungsgehäuse für eine Aufteilung des Luftstroms in verschiedene (Klima-)Zonen angeordnet ist. Die Trennwand trennt dabei Bereiche im Luftführungsgehäuse, die unterschiedlich temperierbar sind. Bei der Trennwand kann es sich auch um eine Trennwand zwischen einem kaltluftführenden und einen warmluftführenden Kanal im Luftführungsgehäuse handeln. in Kombination hiermit kann der Kaltluftkanal auch ganz oder teilweise in eine Wand des Luftführungsgehäuses integriert sein.

Bevorzugt ist das Elektronikbauteil in einem Elektronikgehäuse angeordnet, welches mit dem Luftführungsgehäuse der Klimaanlage über den Kaltluftkanal verbunden ist. Hierbei kann eine direkte Verbindung zwischen Elektronikgehäuse und Luftführungsgehäuse vorgesehen sein, jedoch ist bevorzugt ein elastisches Zwischenelement zwischen den beiden Gehäusen angeordnet oder zumindest ein elastischer Bereich an einem der beiden Gehäuse vorgesehen, welcher die beiden Gehäuse entkoppelt, so dass eine Übertragung von Schwingungen verhindert wird.

Der elastische Bereich kann durch einen Teilbereich einer Wand des Elektronikgehäuses gebildet sein, in welchen ein über das Luftführungsgehäuse überstehender Bereich des Kaltluftkanals eindringt. Hierbei ist bevorzugt der Öffnungsquerschnitt des elastischen Teilbereichs kleiner als der Außenquerschnitt des überstehenden Kaltluftkanals, wobei der Querschnitt nicht notwendigerweise kreisförmig sein muss. Bevorzugt erfolgt die Herstellung des Elektronikgehäuses mittels eines Zwei-Komponenten-Spritzgussverfahrens, wobei der elastische Teilbereich auch nachträglich angespritzt sein kann. Der elastische Teilbereich kann auch durch ein getrennt ausgebildetes elastisches Zwischenelement gebildet sein, welches in eine größere Öffnung in der Wand eingesetzt ist.

Alternativ kann das elastische Zwischenelement mit einer Fläche fest an einer Außenfläche des Luftführungsgehäuses angebracht und mit der gegenüberliegenden Fläche fest mit einer Wand des Elektronikgehäuses verbunden sein. Zusätzlich kann ein über das Luftführungsgehäuse überstehender Bereich des Kaltluftkanals berührungslos in das Elektronikgehäuses eindringen.

Das Elektronikgehäuse, in welchem das mindestens eine Elektronikbauteil oder zumindest mit einem wärmeerzeugenden und/oder abgebenden Bereich angeordnet ist, ist vorzugsweise im Bereich der Mittelkonsole eines Fahrzeugs angeordnet. Dies ermöglicht ohne Veränderung der herkömmlichen Einbaulage der Klimaanlage eine kurze Wegführung des Kaltluftkanals bis zu seinem Zielort.

Insbesondere bevorzugt ist der Kaltluftkanal einstückig mit der Trennwand und/oder dem Luftführungsgehäuse ausgebildet, insbesondere bevorzugt spritzgegossen. Durch eine einstückige Ausgestaltung verringert sich die Anzahl der im Rahmen der Montage zusammenzubauenden Teile, so dass sich der Montageaufwand verringert.

In einer weiteren bevorzugten Ausführungsform, ist das Elektronikbauteil in einem offenen, beispielsweise ein- oder zweiseitig offenen Elektronikgehäuse angeordnet, so dass eine direkte Verbindung über den Kaltluftkanal oder das Luftführungsgehäuse entfallen kann und der Kaftluftkanal vor oder zu einem Anströmbereich an dem offenen Gehäuse geführt ist. Zwischen den beiden Gehäusen kann damit ein elastisches Zwischenelement entfallen.

In einer weiteren vorteilhaften Variante ist das Elektronikbauteil ohne ein dieses ganz oder teilweise umschließendes Gehäuse, beispielsweise an einer Wand angeordnet wobei der Kaltluftkanal hin zu einem Anströmbereich dieser Wand mit dem Elektronikbauteil führt.

Im Folgenden wird die Erfindung anhand mehrerer Ausführungsbeispiele, teilweise mit Varianten und unter Bezugnahme auf die Zeichnung, im Einzelnen erläutert. Es zeigen:

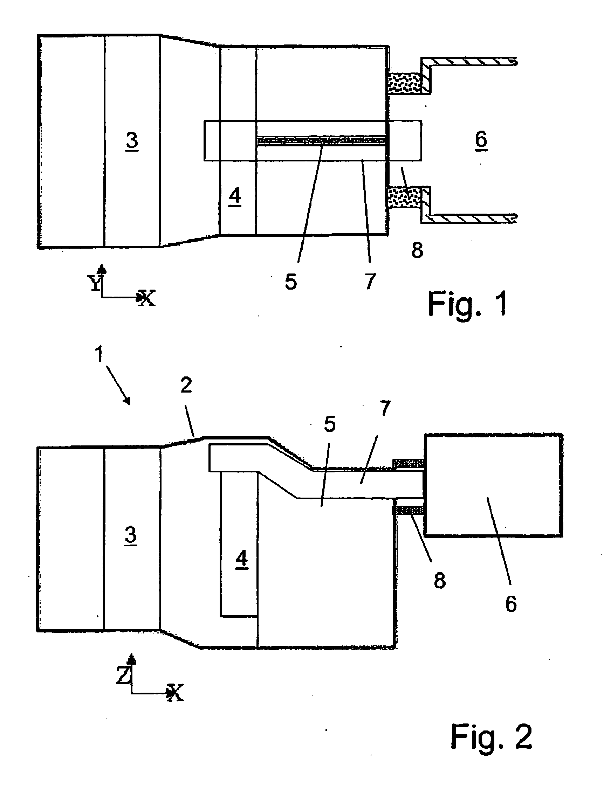

- Fig. 1: eine schematische Darstellung eines Längsschnitts in horizontaler Ebene (xy-Ebene) einer Klimaanlage samt angedeutetem Elektronikgehäuse gemäß dem ersten Ausführungsbeispiel,
- Fig. 2: eine schematische Darstellung eines Längsschnitts in vertikaler Ebene (xz-Ebene) der Klimaanlage samt Elektronikgehäuse von Fig. 1,
- Fig.3: eine schematisierte Detaildarstellung des Übergangsbereichs von Klimaanlage zum Elektronikgehäuse gemäß einer leicht abgewandelten Variante des ersten Ausführungsbeispiels,
- Fig. 4: eine ausschnittsweise Detaildarstellung einer Trennwand, wie sie bei der Klimaanlage von Fig. 1 verwendet wird,
- Fig. 5: eine schematisierte Detaildarstellung des Übergangsbereichs von Klimaanlage zum Elektronikgehäuse gemäß einer zweiten Variante,
- Fig. 6: eine schematisierte Detaildarstellung des Übergangsbereichs von Klimaanlage zum Elektronikgehäuse gemäß einer dritten Variante, und
- Fig. 7: eine schematische Darstellung eines Längsschnitts in horizontaler Ebene einer Klimaanlage samt angedeutetem Elektronikgehäuse zur Verdeutlichung zweier gestrichelt dargestellter, alternativer Verläufe eines in die Mitteltrennwand integrierten Kaltluftkanals zum Elektronikgehäuse.

Eine Kraftfahrzeug-Klimaanlage 1 mit einem in einem Luftführungsgehäuse 2 angeordneten Gebläse (nicht dargestellt), einem Verdampfer 3 und einem Heizer 4 ist vorliegend als zweizonige Klimaanlage mit einer in der Mittellängsebene (xz-Ebene) verlaufenden Trennwand 5 ausgebildet, welche vorliegend im Rahmen der Montage in das Luftführungsgehäuse 2 im wesentlichen spielfrei eingesetzt wird. Im eingebauten Zustand ist die Klimaanlage 1 hinter der Mittelkonsole des Kraftfahrzeugs angeordnet.

In der Mittelkonsole sind ferner Elektronikbauteile (nicht im Einzelnen dargestellt) vorgesehen, welche vorliegend zumindest mit ihrem wärmeerzeugenden Bereich in einem Gehäuse 6, im Folgenden teilweise auch als Elektronikgehäuse bezeichnet, angeordnet sind. Das Gehäuse 6 ist in der Zeichnung stark schematisiert als Kasten dargestellt, jedoch ist seine Gestalt dem Bauraum angepasst, d.h. insbesondere der Rückseite der Mittelkonsole und dem entsprechenden Bereich des Luftführungsgehäuses 2 der Klimaanlage 1.

Um die im und am Gehäuse 6 angebrachten Elektronikbauteile zu kühlen, ist ein Kaltluftbypass, ausgehend von einem Bereich nach dem Verdampfer 3 und vor dem Heizer 4, um den Heizer 4 herum vorgesehen, der im Folgenden als Kaltluftkanal 7 bezeichnet ist. Dieser Kaltluftkanal 7 ist vorliegend ungeregelt ausgebildet, d.h. die Strömungsgeschwindigkeit der Luft im Kaltluftkanal 7 hängt von der Gebläseleistung ab.

Alternativ kann - insbesondere lufteintrittsseitig - eine Klappe für eine bedarfsgerechte Regelung der Luftversorgung der Elektronikbauteile vorgesehen sein. Beispielsweise für den Defrostbetrieb kann die Klappe geschlossen werden, damit die gesamte Luftmenge für eine Entfernung des Scheibenbeschlags zur Verfügung steht.

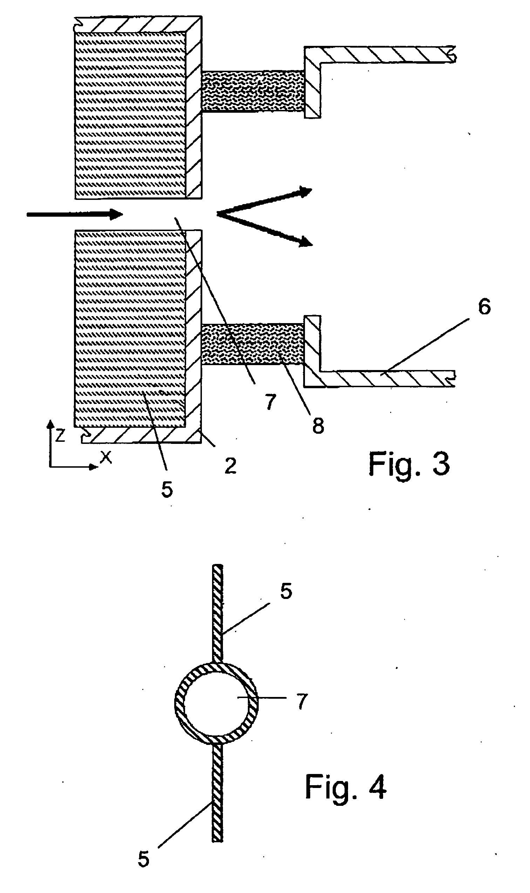

Der Kaltluftkanal 7 weist vorliegend einen im Wesentlichen kreisförmigen Querschnitt auf, wie aus Fig. 4 ersichtlich, und ist einstückig in die Trennwand 5 integriert. Er verläuft - ausgehend von einem oberen Bereich in Bezug auf den vertikalen Querschnitt der Klimaanlage - entlang der Mittellängsebene der Klimaanlage 1 oberhalb des Heizers 4. In Anpassung an den Verlauf des Luftführungsgehäuses 2 folgt der Verlauf des Kaltluftkanals 7 demselben bis zu dessen Endbereich, in welchem auch das Elektronikgehäuse angeordnet ist. Der Kaltluftkanal 7 ist gemäß dem ersten Ausführungsbeispiel stutzenartig überstehend über das Luftführungsgehäuse 2 ausgebildet. Beabstandet vom stutzenförmigen Ende des Kaltluftkanals 7 ist ein ringförmiges, elastisches Zwischenelement 8, vorliegend gebildet durch ein geschlossenzelliges, geschäumtes Material, sowohl an einer Außenfläche des Luftführungsgehäuses 2 als auch an einer gegenüberliegenden Außenfläche des Elektronikgehäuses 6 fest angebracht, bspw. mittels Klebens, wobei das Ende des Kaltluftkanals 7 etwa in Höhe des elektronikgehäuseseitigen Endes des Zwischenelements 8 endet.

Das elastische Zwischenelement 8 dient zum einen der Entkopplung von Luftführungsgehäuse 2 und Elektronikgehäuse 6, d.h. fast keine oder keine Schwingungen werden von der Klimaanlage 1 an die Mittelkonsole übertragen, zum anderen dem Toleranzausgleich zwischen dem beiden Gehäusen 2 und 6, und des weiteren der Abdichtung in Bezug auf die im Kaltluftkanal strömende Luft.

Gemäß einer in Fig. 3 dargestellten Variante, steht der Kaltluftkanal 7 nicht über das Luftführungsgehäuse 2 stutzenartig über, sondern endet bündig mit dem Luftführungsgehäuse 2. Die lüftführungsgehäuseseitig im Elektronikgehäuse 6 vorgesehene Öffnung für den Kaltluftkanal 7 ist auf etwa den Durchmesser des elastischen Zwischenelements 8, der größer als die Austrittsöffnung des Kaltluftkanals 7 ist, erweitert ausgebildet, so dass der kühlende Luftstrom bereits im Zwischenelement 8 etwas aufgeweitet wird und diffus in das Elektronikgehäuse 6 eintritt.

Gemäß einer nicht in der Zeichnung dargestellten Variante weist der Kaltluftkanal einen etwa quadratischen Querschnitt auf, wobei der Querschnittsverlauf über die Länge des Kaltluftkanals sich in Breitenrichtung vergrößert, so dass sich eine rechteckförmige Austrittsöffnung ergibt und der Luftstrom relativ breitflächig in das Elektronikgehäuse eintritt.

Da das Elektronikgehäuse gemäß dem vorliegenden Ausführungsbeispiel und der Varianten hierzu nicht luftdicht ausgebildet ist und eine Mehrzahl von Spalte und Öffnungen aufweist, gelangt die erwärmte Luft in den Bereich hinter der Mittelkonsole und verteilt sich dort.

Alternativ ist auch eine luftdichte Ausgestaltung des Elektronikgehäuses in Verbindung mit einem abführenden Luftkanal, bspw. zum Fußraum (bei starker Wärmeabgabe der Elektronikbauteile ergibt sich so automatisch eine Art Temperaturschichtung im Fahrzeuginnenraum, d.h. die Temperatur im Bereich des Fußraums liegt über der im darüber angeordneten Bereich) oder zur Umgebung hin möglich.

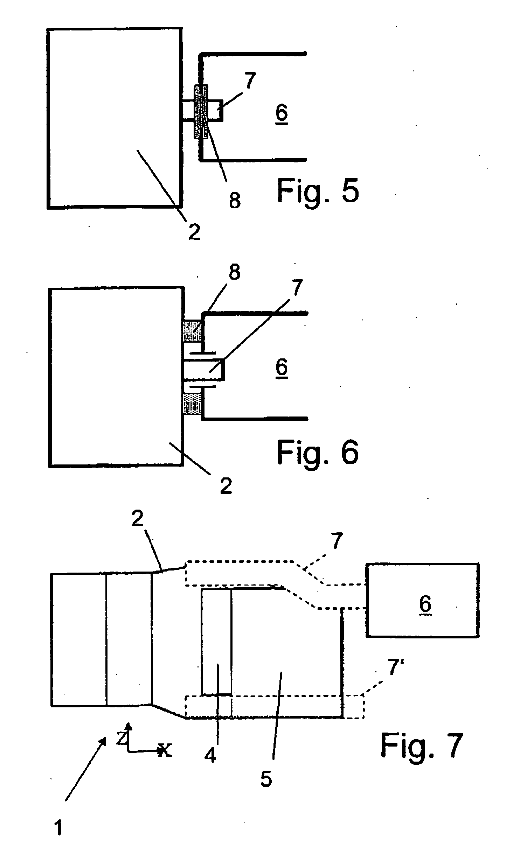

In Fig. 5 ist eine zweite Variante in Bezug auf die Anbringung des Elektronikgehäuses 6 am Luftführungsgehäuse 2 und die Einführung des Kaltluftkanals 7 in das Elektronikgehäuse 6 dargestellt. Hierbei ist der Kaltluftkanal 6 wieder stutzenartig überstehend ausgebildet. Im Unterschied zum ersten Ausführungsbeispiel ist jedoch das elastische Zwischenelement 8 direkt integriert in die luftführungsgehäuseseitige Wand des Elektronikgehäuses 6 integriert ausgebildet, bspw. mittels eines Zwei-Komponenten-Spritzgußverfahrens. Das stutzenartige Ende des Kaltluftkanals 7 ist in eine in dem Zwischenelement 8 ausgebildete Öffnung unter leichter Vorspannung aufgenommen, so dass die Innenfläche des Zwischenelements 8 flächig am Außenumfang des stutzenartigen Endes anliegt und ein Austreten von Luft verhindert wird.

Gemäß der in Fig. 6 dargestellten, dritten Variante in Bezug auf die Anbringung des Elektronikgehäuses 6 am Luftführungsgehäuse 2 ist am Luftführungsgehäuse 2 ein ringförmiges, elastisches Zwischenelement 8 angebracht, bspw. angeklebt. Gegenüberliegend vom Luftführungsgehäuse 2 ist das Elektronikgehäuse 6 am elastischen Zwischenelement 8 angebracht, bspw. ebenfalls angeklebt. In der Seitenwand des Elektronikgehäuses 6 ist eine Öffnung vorgesehen, die größer als der stutzenartig über das Luftführungsgehäuse 2 überstehende Kaltluftkanal 7 ausgebildet ist. Dabei ragt das Ende des Kaltluftkanals 7 bis in das Elektronikgehäuse 6 hinein, ohne dass der Kaltluftkanal 7 das Elektronikgehäuse 6 berührt. Zur Vermeidung von Geräuschen ist ein ausreichend großer Spalt zwischen der Außenfläche des Kaltluftkanals 7 und der Innenfläche der Öffnung vorgesehen. Aus strömungstechnischen Gründen sowie zur Verstärkung der Wandfläche des Elektronikgehäuses 6 ist im Bereich der Öffnung ein in beide Seiten vorstehender Rand ausgebildet.

In Fig. 7 sind beispielhaft zwei Verläufe von Kaltluftkanälen 7 bzw. 7' angedeutet. Zur Vereinfachung der Darstellung ist das elastische Zwischenelement nicht dargestellt. Ferner ist der weitere Verlauf des Kaltluftkanals 7' zum Elektronikgehäuse 6 nicht dargestellt.

Wie in Fig. 7, oben dargestellt, verläuft der Kaftluftkanal 7 im Wesentlichen im Grenzbereich der oberen Außenwand des Luftführungsgehäuses 2 und der Trennwand 5, wobei der Kaltluftkanal 7 über einen Teil seines Umfangs vom Luftführungsgehäuse 2 und über den restlichen Teil seines Umfangs durch einen entsprechend ausgebildeten Bereich der Trennwand 5 gebildet ist.

Gemäß dem in Fig. 7, unten dargestellten Kaltluftkanal 7' ist ein Verlauf unterhalb des Heizers 4 in direkter Nachbarschaft zur Außenwand des Luftführungsgehäuses 2 integriert in die Trennwand 5 und die Außenwand vorgesehen. Die Überleitung des Kaltluftkanals 7' in Richtung des oberhalb angeordneten Elektronikgehäuses 6 erfolgt durch eine geeignete Kanalführung vorbei an den vom Luftführungsgehäuse 2 abzweigenden Luftkanälen zum Fahrzeuginnenraum.

Der Kaltluftkanal zum Elektronikgehäuse kann alternativ auch in einer im Wesentlichen horizontal verlaufenden Trennwand angeordnet sein, bspw. wenn es sich um eine vierzonige Klimaanlage handelt.

Gemäß einem zweiten, nicht in der Zeichnung dargestellten Ausführungsbeispiel verläuft der Kaltluftkanal integriert in eine der Außenwände des Luftführungsgehäuses der Klimaanlage zum Elektronikgehäuse. Der Kaltluftkanal kann - je nach vorhandenem Bauraum - oberhalb, unterhalb oder ggf. auch seitlich am Heizer vorbei verlaufend ausgestaltet sein. Hierbei ist der Kaltluftkanal zumindest bereichsweise bevorzugt einstückig mit dem Luftführungsgehäuse der Klimaanlage ausgebildet.

Gemäß einer Variante kann jedoch auch ein Kanal von außen an das Luftführungsgehäuse angebracht werden. Dies ermöglicht beispielsweise eine Art Baukastenprinzip, wenn das Luftführungsgehäuse mit einem herausbrechbaren oder auf andere Weise entfernbaren Bereich für den Beginn des Kaltluftkanals ausgebildet ist. Hierbei kann die Öffnung auch mittels einer Klappe verschlossen sein, die nur im Falle eines Kaltluftkanals zum Elektronikgehäuse mit einem Aktuator versehen oder beständig geöffnet ist.

Eine weitere Variante in Bezug auf die Führung des Kaltluftkanals bietet eine geteilte Ausgestaltung des Heizers. In diesem Fall kann der Kaltluftkanal durch die Lücke zwischen den beiden Heizbereichen geführt werden.

Der Kaltluftkanal kann - insbesondere in Verbindung mit einer geteilten Ausgestaltung des Heizers - auch durch eine doppelwandige Trennwand gebildet sein. Dies ermöglicht, dass über nahezu die gesamte Höhe des Luftführungsgehäuses ein kleiner Luftstrom in den schmalen Kaltluftkanal gelangen und zu den Elektronikbauteilen im Elektronikgehäuse geführt werden kann.

Um auch im Falle einer ausgeschalteten Klimaanlage eine Kühlung der Elektronikbauteile sicherstellen zu können, werden im Falle eines manuellen Ausschalten der Klimaanlage bzw. des Gebläses derselben lediglich alle Luftausgänge zum Fahrzeuginnenraum durch Klappen verschlossen. Das Gebläse läuft - ggf. mit minimaler Drehzahl - weiter, um weiter für eine Kühlung der Elektronikbauteile zu sorgen.

Alternativ kann auch ein kleiner Zusatzlüfter vorgesehen sein, der ausschließlich im Falle einer ausgeschalteten Klimaanlage tätig wird.

### Bezugszeichenliste

- 1: Klimaanlage
- 2: Luftführungsgehäuse
- 3: Verdampfer
- 4: Heizer
- 5: Trennwand
- 6: Gehäuse, Elektronikgehäuse
- 7, 7': Kaltluftkanal
- 8: Zwischenelement

## Patentansprüche

1. Vorrichtung zur Kühlung von mindestens einem Elektronikbauteil, aufweisend eine Klimaanlage (1), insbesondere Kraftfahrzeug-Klimaanlage (1), mit einem Luftführungsgehäuse (2), in welchem ein Verdampfer (3) und ein Heizer (4) angeordnet sind, und von dem mindestens ein Luftkanal abzweigt, über welchen temperierte Luft einem Innenraum zuführbar ist, wobei ein Kaltluftkanal (7, 7') vorgesehen ist, der hinter dem Verdampfer (3) und vor dem Heizer (4) abzweigt, welcher zum Elektronikbauteil führt, **dadurch gekennzeichnet, dass** der Kaltluftkanal (7, 7') in eine Trennwand (5) integriert ist, die im Luftführungsgehäuse (2) angeordnet ist.

2. Vorrichtung nach Anspruch 1, **dadurch gekennzeichnet, dass** der Kaltluftkanal (7, 7') in eine Wand des Luftführungsgehäuses (2) integriert ist.

3. Vorrichtung nach einem der vorhergehenden Ansprüche, **dadurch gekennzeichnet, dass** der Kaltluftkanal (7, 7') einstückig mit dem Luftführungsgehäuse (2) und/oder der Trennwand (5) im Luftführungsgehäuse (2) ausgebildet ist.

4. Vorrichtung nach Anspruch 3, **dadurch gekennzeichnet, dass** der Kaltluftkanal (7, 7') einstückig spritzgegossen mit der Trennwand (5) und/oder dem Luftführungsgehäuse (2) ist.

5. Vorrichtung nach einem der vorhergehenden Ansprüche, **dadurch gekennzeichnet, dass** das Elektronikbauteil in einem Elektronikgehäuse (6) angeordnet ist, welches mit dem Luftführungsgehäuse (2) der Klimaanlage (1) über den Kaltluftkanal (7, 7') verbunden ist.

6. Vorrichtung nach Anspruch 5, **dadurch gekennzeichnet, dass** das Elektronikgehäuse (6) und das Luftführungsgehäuse (2) über einen elastisch ausgebildeten Bereich oder ein elastisches Zwischenelement (8) miteinander verbunden sind.

7. Vorrichtung nach Anspruch 6, **dadurch gekennzeichnet, dass** der elastische Bereich durch einen Teilbereich einer Wand des Elektronikgehäuses (6) gebildet ist, in welchen ein über das Luftführungsgehäuse (2) überstehender Bereich des Kaltluftkanals (7, 7') eindringt.

8. Vorrichtung nach Anspruch 7, **dadurch gekennzeichnet, dass** das elastische Zwischenelement (8) mit einer Fläche fest an einer Außenfläche des Luftführungsgehäuses (2) angebracht und mit der gegenüberliegenden Fläche fest mit einer Wand des Elektronikgehäuses (6) verbunden ist, und dass ein über das Luftführungsgehäuse (2) überstehender Bereich des Kaltluftkanals (7, 7') berührungslos in das Elektronikgehäuses (6) eindringt.

9. Fahrzeug mit einer Vorrichtung nach einem der vorhergehenden Ansprüche, **dadurch gekennzeichnet, dass** das Elektronikbauteil im Bereich der Mittelkonsole eines Fahrzeugs angeordnet ist.

10. Fahrzeug mit einer Vorrichtung nach einem der Anspruch 5 - 8, **dadurch gekennzeichnet, dass** das Elektronikgehäuse (6) unterhalb der Mittelkonsole des Fahrzeugs angeordnet ist.

## Claims

1. A device for cooling at least one electronic component, comprising an air conditioning system (1), in particular motor vehicle air conditioning system (1), with an air supply housing (2) in which a vaporizer (3) and a heater (4) are arranged and from which at least one air channel diverges through which tempered air can be supplied to an inner chamber, wherein an cold air channel (7, 7') is provided which diverges behind the vaporizer (3) and before the heater (4) and which runs to the electronic component, **characterized in that** the cold air channel (7, 7') is integrated in a separation wall (5) which is arranged in the air supply housing (2).

2. The device according to claim 1, **characterized in that** the cold air channel (7, 7') is integrated in a wall of the air supply housing (2).

3. The device according to any one of the preceding claims, **characterized in that** the cold air channel (7, 7') is formed integrally with the air supply housing (2) and/or the separation wall (5) in the air supply housing (2).

4. The device according to claim 3, **characterized in that** the cold air channel (7, 7') is integrally injection molded with the separation wall (5) and/or the air supply housing (2).

5. The device according to any one of the preceding claims, **characterized in that** the electronic component is arranged in an electronic housing (6) which is connected with the air supply housing (2) of the air conditioning system (1) via the cold air channel (7, 7').

6. The device according to claim 5, **characterized in that** the electronic housing (6) and the air supply housing (2) are connected with one another via an elastically formed region or an elastic intermediate element (8).

7. The device according to claim 6, **characterized in that** the elastic region is formed by a section of a wall of the electronic housing (6), into which section a region of the cold air channel (7, 7') penetrates which region projects beyond the air supply housing (2).

8. The device according to claim 7, **characterized in that** the elastic intermediate element (8) is fixedly attached with one face on an outer face of the air supply housing (2) and is fixedly connected with the opposite face to a wall of the electronic housing (6), and that a region of the cold air channel (7, 7') projecting beyond the air supply housing (2) penetrates contactless into the electronic housing (6).

9. A vehicle with a device according to any one of the preceding claims, **characterized in that** the electronic component is arranged in the region of the center console of a vehicle.

10. The vehicle with a device according to any one of the claims 5 to 8, **characterized in that** the electronic housing (6) is arranged below the center console of the vehicle.

## Revendications

1. Dispositif de refroidissement d'au moins un composant électronique, présentant un système de climatisation (1), en particulier un système de climatisation de véhicule automobile (1), comprenant un carter de guidage d'air (2) dans lequel sont disposés un évaporateur (3) et un dispositif de chauffage (4), carter de guidage d'air duquel part au moins un conduit d'air par lequel de l'air tempéré peut être fourni à un habitacle, où il est prévu un conduit d'air froid (7, 7') dont le départ se situe derrière l'évaporateur (3) et devant le dispositif de chauffage (4), lequel conduit d'air froid mène au composant électronique,
**caractérisé en ce que** le conduit d'air froid (7, 7') est intégré dans une paroi de séparation (5) qui est disposée dans le carter de guidage d'air (2).

2. Dispositif selon la revendication 1, **caractérisé en ce que** le conduit d'air froid (7, 7') est intégré dans une paroi du carter de guidage d'air (2).

3. Dispositif selon l'une ou l'autre des revendications précédentes, **caractérisé en ce que** le conduit d'air froid (7, 7') est configuré dans le carter de guidage d'air (2), en formant une seule et même pièce avec le carter de guidage d'air (2) et / ou la paroi de séparation (5).

4. Dispositif selon la revendication 3, **caractérisé en ce que** le conduit d'air froid (7, 7') est moulé par injection en formant une seule et même pièce avec la paroi de séparation (5) et / ou le carter de guidage d'air (2).

5. Dispositif selon l'une quelconque des revendications précédentes, **caractérisé en ce que** le composant électronique est disposé dans un boîtier électronique (6) qui est raccordé, par le conduit d'air froid (7, 7'), au carter de guidage d'air (2) du système de climatisation (1).

6. Dispositif selon la revendication 5, **caractérisé en ce que** le boîtier électronique (6) et le carter de guidage d'air (2) sont raccordés l'un à l'autre par une zone configurée de façon élastique ou bien par un élément intercalaire élastique (8).

7. Dispositif selon la revendication 6, **caractérisé en ce que** la zone élastique est formée par une zone partielle d'une paroi du boîtier électronique (6), zone élastique dans laquelle s'engage une zone du conduit d'air froid (7, 7') dépassant du carter de guidage d'air (2).

8. Dispositif selon la revendication 7, **caractérisé en ce que** l'élément intercalaire élastique (8), par une surface, est monté fixement sur une surface extérieure du carter de guidage d'air (2) et, par la surface opposée, raccordé fixement à une paroi du boîtier électronique (6), et **en ce qu'**une zone du conduit d'air froid (7, 7') dépassant du carter de guidage d'air (2) pénètre, sans contact, dans le boîtier électronique (6).

9. Véhicule comprenant un dispositif selon l'une quelconque des revendications précédentes, **caractérisé en ce que** le composant électronique est disposé dans la zone de la console centrale d'un véhicule.

10. Véhicule comprenant un dispositif selon l'une quelconque des revendications 5 à 8, **caractérisé en ce que** le boîtier électronique (6) est disposé au-dessous de la console centrale du véhicule.
